# FASCICULE DE BREVET EUROPEEN

(11) **EP 4 055 635 B1**
(45) Date de publication et mention de la délivrance du brevet: **25.10.2023**
(21) Numéro de dépôt: 20861951.0
(22) Date de dépôt: 12.11.2020
(51) Int. Cl.: H01L 31/048, H01L 31/18

(54) **PROCÉDÉ DE FABRICATION ET D'INSPECTION D'UN ASSEMBLAGE PHOTOVOLTAÏQUE AVEC RÉTICULATION PARTIELLE**
VERFAHREN ZUR HERSTELLUNG UND PRÜFUNG EINER PHOTOVOLTAISCHEN ANORDNUNG MIT TEILWEISER VERNETZUNG
METHOD FOR FABRICATING AND INSPECTING A PHOTOVOLTAIC ASSEMBLY WITH PARTIAL CROSSLINKING

(30) Priorité: 16.12.2019 FR 1914470
(43) Date de publication de la demande: 14.09.2022
(73) Titulaire: Commissariat à l'Énergie Atomique et aux Énergies Alternatives, 75015 Paris (FR)
(72) Inventeur: VOARINO, Philippe, 38054 GRENOBLE CEDEX 09 (FR); CARIOU, Romain, 38054 GRENOBLE CEDEX 09 (FR)
(74) Mandataire: Brevalex
(86) Numéro de dépôt international: PCT/FR2020/052059
(87) Numéro de publication internationale: WO 2021/123524

(56) Documents cités:
- EP-A2- 2 166 576
- JP-A- 2002 026 358
- US-A- 4 170 507
- US-A1- 2010 240 153

## Description

### DOMAINE TECHNIQUE

La présente invention se rapporte au domaine des modules photovoltaïques, qui comportent un ensemble de cellules photovoltaïques reliées entre elles électriquement, et préférentiellement des cellules photovoltaïques dites « cristallines », c'est-à-dire qui sont à base de silicium monocristallin ou multicristallin, de matériaux III-V, de couches minces (CIGS, CdTE, perovskites, etc.) ou toute combinaison de ces différents matériaux. En particulier, l'invention est concernée par la problématique de collage/encapsulation et décollage/séparation de modules photovoltaïques vis-à-vis d'un support en contact avec les modules photovoltaïques.

L'invention concerne le domaine des modules photovoltaïques utilisés pour des applications spatiales, mais aussi pour des applications terrestres, et également pour des applications de type mobilité électronique, ballons ou drones, entre autres. De manière plus générale, l'invention s'applique aux applications photovoltaïques pour lesquelles la problématique de collage, décollage, réparation et/ou recyclage est pertinente.

L'invention propose ainsi un procédé de fabrication et d'inspection d'un assemblage photovoltaïque avec une étape de réticulation partielle.

### ÉTAT DE LA TECHNIQUE ANTÉRIEURE

Un module photovoltaïque terrestre est classiquement constitué de cellules photovoltaïques électriquement connectées entre elles, généralement en série, et encapsulées dans un empilement de matériaux de type polymère et/ou verre. Cet empilement permet de protéger les cellules photovoltaïques de l'environnement extérieur, comme par exemple de la pluie, du vent, de la neige, de l'humidité, des rayonnements ultraviolets, des radiations, des chocs thermiques, entre autres, tout en conservant la fonction de conversion photoélectrique.

Ainsi, classiquement, un module photovoltaïque terrestre forme un empilement comportant successivement: un élément de protection arrière appelé « backsheet » en anglais, transparent ou non ; un premier film de polymère, généralement d'éthylène acétate de vinyle (EVA) ; des cellules photovoltaïques reliées électriquement entre elles, typiquement par des rubans de cuivre étamé; un deuxième film de polymère, généralement d'éthylène acétate de vinyle (EVA) ; un élément de protection avant appelé « frontsheet » en anglais, transparent, comme par exemple une plaque de verre ou un film polymère.

L'élément de protection avant est destiné à transmettre le rayonnement solaire aux cellules photovoltaïques pour générer de l'électricité, tout en les protégeant des contraintes de l'environnement. Cet empilement est ensuite solidarisé lors d'une étape de lamination à chaud, typiquement entre 100 et 150°C, pour faire fondre les films en EVA et provoquer la réticulation de l'EVA fondu, d'où il résulte la formation d'une enveloppe d'encapsulation solide des cellules photovoltaïques collée aux éléments de protection avant et arrière.

Lors de l'étape de lamination, la réticulation de l'encapsulant est irréversible et permet d'obtenir un ensemble compact. Les modules photovoltaïques ainsi obtenus ne sont pas réparables, à savoir que les différentes couches de matériaux et les assemblages photovoltaïques ne peuvent pas être délaminés, donc séparés, et remplacés simplement en cas de défaut ou pour recyclage. Ainsi, la séparation des matériaux en fin de vie pour ce type de module photovoltaïque terrestre est destructive, et des étapes de broyage et de filtrage sont nécessaires.

Par ailleurs, un module photovoltaïque spatial classique est constitué d'assemblages de cellules photovoltaïques collés sur un substrat rigide de type nid d'abeilles. La structure et le type de cellules photovoltaïques utilisés diffèrent des modules photovoltaïques terrestres pour s'adapter aux contraintes environnementales et techniques drastiques du spatial (radiations, températures, vide, etc.). Ainsi, chaque cellule photovoltaïque est protégée par un verre individuel en face avant, solidarisé par le biais d'un adhésif transparent à la cellule, de sorte à former un ensemble appelé CIC pour « Coverglass Interconnect Cell » en anglais. Cet ensemble CIC est collé de manière permanente sur le substrat ou support mécanique par le biais d'un adhésif. Parmi les générations de panneaux solaires en cours de développement, certaines remplacent le CIC par un assemblage de cellules, donc un module, qui est lui-même collé sur un support mécanique.

Les colles utilisées, typiquement à base de silicone, offrent une bonne résistance à l'environnement spatial mais ne permettent pas de décollement facile en cas de besoin de réparation ou de recyclage. Aussi, lors des étapes de contrôle avant mise en orbite, par exemple lors d'un test d'électroluminescence, les cellules et assemblages photovoltaïques identifiés comme défectueux sont décollés de manière manuelle et mécanique au niveau de la colle réticulée, le plus souvent mécaniquement à l'aide d'un scalpel. Or, le support ou les couches de matériaux en contact peuvent avoir des fonctions mécaniques, électriques (transfert de signaux, de puissance électrique, isolation, etc.) et/ou des fonctions protectrices vis-à-vis de l'environnement extérieur qui sont détériorées par cette opération de décollement manuel.

Le brevet américain US 7,998,760 B2 propose l'utilisation d'une colle conductrice pour établir un contact électrique entre une cellule solaire et un ruban conducteur. Le collage est réalisé dans une première condition de température et de pression, suivi d'une étape d'inspection de la qualité électrique de la cellule et de la connexion formée. En cas de défaut après inspection, les cellules peuvent être décollées pour être remplacées. Ce brevet est axé sur la partie connectique et ne traite pas de la partie relative à l'encapsulation et au collage sur un substrat.

Par ailleurs, la demande de brevet japonais JP 2002-026358 A enseigne l'amélioration de la réparabilité locale d'un module solaire grâce à l'utilisation d'une résine thermoplastique pour sceller le module avec un changement de phase vers 190°C. L'invention est concernée par les défauts liés à la manutention des modules solaires, tels que des rayures ou des chocs entraînant une rupture d'herméticité. Le changement de phase de l'encapsulant, localement sur la zone de chauffage, peut aider à corriger ces défauts. Aucun enseignement n'est relatif au changement intégral des cellules solaires en cas de casse. Le document EP 2166576 A2 décrit un procédé de fabrication d'un module photovoltaïque comprenant une étape de déposition des cellules photovoltaïques sur un support comprenant une couche adhésive partiellement réticulée.

### EXPOSÉ DE L'INVENTION

L'invention a pour but de remédier au moins partiellement aux besoins mentionnés ci-dessus et aux inconvénients relatifs aux réalisations de l'art antérieur.

En particulier, l'invention vise à permettre la fabrication d'un assemblage photovoltaïque comprenant un ou plusieurs modules photovoltaïques sur un support, et le contrôle du bon fonctionnement du ou des modules photovoltaïques par inspection afin d'effectuer une éventuelle opération de réparation de l'assemblage.

L'invention a ainsi pour objet, selon l'un de ses aspects, un procédé de fabrication et d'inspection d'un assemblage photovoltaïque, comportant :
- un support,
- au moins un module photovoltaïque, comprenant au moins une cellule photovoltaïque, notamment une pluralité de cellules photovoltaïques reliées électriquement entre elles et disposées côte à côte, entre une première couche transparente formant une face avant dudit au moins un module photovoltaïque et le support,
- au moins une couche d'adhésion à base d'un matériau polymère réticulable, disposée entre le support et ledit au moins un module photovoltaïque,
caractérisé en ce qu'il comporte les étapes suivantes :
- une étape A) de dépose de ladite au moins une couche d'adhésion sur le support,
- une étape B) d'assemblage dudit au moins un module photovoltaïque sur le support recouvert de ladite au moins une couche d'adhésion,
- une étape C) de réticulation partielle, encore appelée pré-réticulation, à savoir avantageusement réalisée préalablement à une étape de finalisation de la réticulation de sorte à obtenir une adhésion temporaire et/ou réversible, de ladite au moins une couche d'adhésion à base d'un matériau polymère réticulable pour former au moins une couche d'adhésion partiellement réticulée, présentant un pouvoir d'adhésion autorisant un enlèvement ultérieur dudit au moins un module photovoltaïque en cas de besoin, notamment au cours de l'étape G) décrite ci-après,
- une étape D) de connexion électrique consistant à relier électriquement ledit au moins un module photovoltaïque à des moyens de connexion électrique du support,
- une étape E) d'inspection du fonctionnement électrique et mécanique dudit au moins un module photovoltaïque, éventuellement en lien avec le support,
- en cas de fonctionnement correct détecté à l'issue de l'étape E), une étape F) de finalisation de la réticulation de ladite au moins une couche d'adhésion partiellement réticulée,
- en cas de fonctionnement incorrect détecté à l'issue de l'étape E), une étape G) d'enlèvement d'au moins un module photovoltaïque défectueux, puis retour à l'étape A) en vue de l'assemblage d'un ou plusieurs nouveaux modules photovoltaïques.

Par « matériau polymère réticulable », on entend un matériau polymère apte à être réticulé, dont l'état peut passer à un état réticulé. Un matériau polymère réticulable présente notamment un degré de réticulation strictement inférieur au point de gel de ce matériau polymère. Notamment, le matériau polymère réticulable est à l'état liquide. Par « matériau à l'état liquide », il est entendu que le matériau a tendance à couler en raison de la faible cohésion des molécules qui le compose. Notamment, l'état liquide du matériau polymère réticulable est tel que ce matériau polymère réticulable présente une viscosité préférentiellement comprise entre 0,1 Pa.s et 100 Pa.s, et préférentiellement entre 1 Pa.s et 50 Pa.s à une température de 25°C. Dans la présente description, les valeurs de viscosités sont données à la pression atmosphérique.

Le procédé de fabrication selon l'invention peut en outre comporter l'une ou plusieurs des caractéristiques suivantes prises isolément ou suivant toutes combinaisons techniques possibles.

L'étape G) peut être suivie d'une étape H) de nettoyage du support à l'endroit d'enlèvement dudit au moins un module photovoltaïque défectueux avant retour à l'étape A).

Ladite au moins une couche d'adhésion à base d'un matériau polymère réticulable peut être avantageusement à l'état liquide.

Préférentiellement, ledit au moins un module photovoltaïque peut comporter une première couche transparente formant une face avant dudit au moins un module photovoltaïque, une deuxième couche, ou encore un substrat, formant une face arrière dudit au moins un module photovoltaïque, et une pluralité de cellules photovoltaïques reliées électriquement entre elles et disposées côte à côte entre la première couche et la deuxième couche. Dans ce cas, la face arrière du module peut être collée par la couche d'adhésion au support, typiquement sous forme de voile solaire.

Le support peut être rigide ou souple. Par exemple, le support peut être rigide et prévu pour des applications spatiales. En particulier, le support peut comporter une structure en nid d'abeilles, par exemple en aluminium. En variante, le support peut être souple, étant par exemple réalisé en polyimide, par exemple un film Kapton^{®}, en polyétheréthercétone (PEEK) ou encore en matériau thermoplastique filé à partir d'un aramide, par exemple un film Vectran^{®}, entre autres.

En outre, le support peut être de faible épaisseur. Par exemple, l'épaisseur du support peut être comprise entre 10 µm et 5 mm, préférentiellement entre 25 et 125 µm.

La technique de dépose de ladite au moins une couche d'adhésion sur le support peut être variable. Elle peut par exemple correspondre à une technique par enduction ou par spray. Elle est avantageusement choisie de sorte à ne pas rajouter inutilement de la masse à l'assemblage photovoltaïque par un excès d'adhésif.

Par ailleurs, de façon avantageuse, ladite au moins une couche d'adhésion n'est pas appliquée sur la totalité de la surface du support. En effet, la dépose de ladite au moins une couche d'adhésion est avantageusement réalisée sur une partie ou sur la totalité de la surface du support destinée à recevoir ledit au moins un module photovoltaïque.

L'épaisseur de ladite au moins une couche d'adhésion peut être comprise entre 10 µm et 1 mm, préférentiellement entre 50 µm et 200 µm.

Avantageusement, l'épaisseur de ladite au moins une couche d'adhésion est choisie de manière à éviter l'endommagement du support et/ou dudit au moins un module photovoltaïque en cas d'enlèvement ou décollage, à assurer une adhésion suffisante au cours de la vie de l'assemblage photovoltaïque, et à éviter l'ajout inutile de masse.

Par ailleurs, avantageusement, l'étape B) d'assemblage peut précéder l'étape C) de réticulation partielle. En variante, l'étape B) d'assemblage peut suivre l'étape C) de réticulation partielle.

En outre, le taux de réticulation moyen mis en oeuvre lors de l'étape C) de réticulation partielle peut être compris entre 10 % et 60 %, préférentiellement entre 20 % et 50 %, en volume ou en masse. Il faut noter qu'entre le module et le support, certaines zones peuvent être non réticulées et d'autres réticulées à plus de 60 %.

Avantageusement, le matériau polymère réticulable de ladite au moins une couche d'adhésion peut être choisi parmi la famille des silicones. En particulier, il peut s'agir d'un matériau de type « UV cure RTV (pour « Room Température Vulcanization ») silicone » avec une épaisseur comprise entre 10 µm et 1 mm, préférentiellement entre 50 µm et 200 µm.

En particulier, tout matériau polymère réticulable visé dans la présente description peut comporter, notamment être constitué de, deux composants A et B. Le composant A est une base, par exemple de type PDMS (pour polydiméthylsiloxane). Le composant B contient un agent vulcanisant, comme par exemple le polysiloxane, et un catalyseur pour permettre aux chaînes de polymère de se ramifier pour former un réseau tridimensionnel de sorte que le matériau polymère réticulable puisse, au terme de sa réticulation, former une couche correspondante en matériau solide et infusible.

Le matériau polymère réticulable peut être choisi parmi : Sylgard ^{®} 184 de l'entreprise Dow Corning, Dow Corning ^{®} 93-500, Siltech ^{®} CR 12-63, Siltech ^{®} CR 13-46, Elastosil ^{®} RT 625 de l'entreprise Wacker, Elastosil ^{®} S 691 de l'entreprise Wacker, MAPSIL ^{®} 213 de l'entreprise MAP COATING, MAPSIL ^{®} 213B de l'entreprise MAP COATING, et MAPSIL ^{®} QSI 123 de l'entreprise MAP COATING.

Par ailleurs, l'étape E) d'inspection du fonctionnement électrique et mécanique dudit au moins un module photovoltaïque peut comprendre la réalisation d'un test électrique de chaque ensemble d'une ou plusieurs cellules photovoltaïques dudit au moins un module photovoltaïque, notamment un test d'électroluminescence, de photoluminescence, de type DIV (Dark IV) et/ou de type LIV (Light IV), tels que décrits dans les normes IEC 60904, EN 61215 et IEC 62108.

L'étape F) de finalisation de la réticulation de ladite au moins une couche d'adhésion partiellement réticulée peut en outre être réalisée par exposition de l'assemblage photovoltaïque à température ambiante, notamment entre 20 et 30°C, pendant une durée supérieure à 24h. En variante, l'étape F) de finalisation de la réticulation de ladite au moins une couche d'adhésion partiellement réticulée peut être réalisée par exposition de l'assemblage photovoltaïque à un apport d'énergie externe, notamment par chauffage ou exposition à des ondes infrarouges et/ou ultraviolettes.

De plus, l'étape F) de finalisation de la réticulation peut être suivie d'une étape E) additionnelle d'inspection.

L'étape F) de finalisation de la réticulation peut encore être suivie d'une étape de pliage de l'assemblage photovoltaïque, notamment d'un pliage en Z.

De même, l'étape E) d'inspection peut être précédée d'une étape de pliage de l'assemblage photovoltaïque, notamment d'un pliage en Z.

Par ailleurs, l'étape C) de réticulation partielle de ladite au moins une couche d'adhésion à base d'un matériau polymère réticulable peut comporter la réticulation partielle du volume total de ladite au moins une couche d'adhésion.

En variante, l'étape C) de réticulation partielle de ladite au moins une couche d'adhésion à base d'un matériau polymère réticulable peut comporter la réticulation partielle du volume total de ladite au moins une couche d'adhésion. En particulier, la réticulation partielle peut être réalisée sur une ou plusieurs zones de la surface de ladite au moins une couche d'adhésion, notamment sous la forme d'un ou plusieurs motifs, et/ou sur une partie ou la totalité de l'épaisseur de ladite au moins une couche d'adhésion.

### BRÈVE DESCRIPTION DES DESSINS

L'invention pourra être mieux comprise à la lecture de la description détaillée qui va suivre, d'exemples de mise en oeuvre non limitatifs de celle-ci, ainsi qu'à l'examen des figures, schématiques et partielles, du dessin annexé, sur lequel :
La figure 1 représente, selon une vue éclatée en perspective, un exemple de module, ou assemblage, photovoltaïque spatial rigide,
La figure 2 représente un schéma-blocs illustratif d'un procédé de fabrication d'un assemblage photovoltaïque conforme à l'invention,
La figure 3A illustre, partiellement en vue de dessus, un exemple d'assemblage photovoltaïque spatial obtenu par le procédé de fabrication conforme à l'invention,
La figure 3B représente, selon une vue en coupe, un exemple de module photovoltaïque de l'assemblage de la figure 3A
La figure 4 illustre, partiellement en perspective, le pliage de l'assemblage photovoltaïque de la figure 3A,
Les figures 5A, 5B, 5C, 5D et 5E représentent, selon une vue de dessus, différents exemples de réticulation partielle d'une couche d'adhésion d'un assemblage photovoltaïque lors du procédé de fabrication conforme à l'invention,
Les figures 6A et 6B représentent, selon une vue de côté, différents exemples de réticulation partielle en épaisseur pour l'exemple de la figure 5B, et
Les figures 7A et 7B représentent, selon une vue de côté, un exemple de réticulation partielle en épaisseur pour l'exemple de la figure 5C.

Dans l'ensemble de ces figures, des références identiques peuvent désigner des éléments identiques ou analogues.

De plus, les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Dans la description des exemples de mise en oeuvre de l'invention qui vont suivre, le domaine d'application concerné est celui des modules photovoltaïques pour des applications spatiales. Toutefois, l'invention s'applique aussi aux modules photovoltaïques prévus pour des applications terrestres.

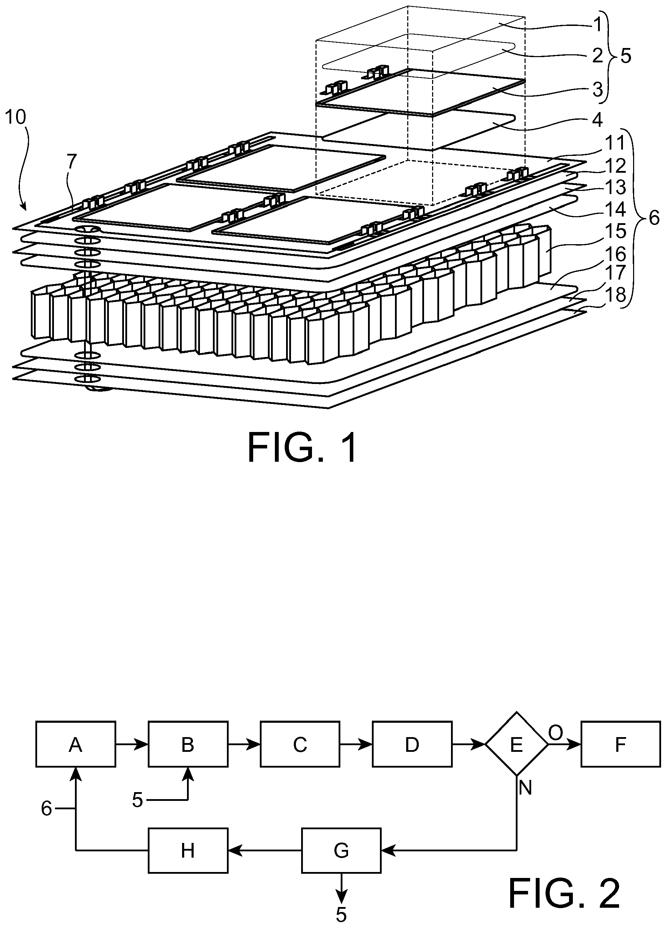

La figure 1 illustre tout d'abord, selon une vue éclatée en perspective, un exemple de module, ou assemblage, photovoltaïque 10 spatial rigide.

Dans cet exemple, l'assemblage photovoltaïque 10 comporte un support rigide 6 sur lequel est collée une pluralité de modules photovoltaïques 5 de type CIC pour « Coverglass Interconnect Cell » en anglais.

Le support rigide 6 comporte successivement (de haut en bas) : une couche isolante 11 sur laquelle sont collés les modules photovoltaïques 5 ; une couche d'adhésif 12 ; une couche polymère 13 ; une couche d'adhésif 14 ; une structure en nid d'abeilles 15 ; une couche d'adhésif 16 ; une couche polymère 17 ; et une couche de contrôle thermique 18.

Par ailleurs, chaque module photovoltaïque 5 de type CIC comporte : une face avant 1 en verre ; une couche d'adhésif transparent 2 ; et une ou plusieurs cellules photovoltaïques 3.

Une couche d'adhésion 4 est utilisée entre chaque module photovoltaïque 5 et le support rigide 6 pour permettre la fixation des modules photovoltaïques 5 sur le support rigide 6 et notamment par le biais d'une adhésion sur la couche 11, et ainsi la fabrication de l'assemblage photovoltaïque 10.

En outre, les modules photovoltaïques 5, une fois collés, sont connectés électriquement à des moyens de connexion électrique 7, notamment des harnais électriques, présents sur le support rigide 6.

Des étapes manuelles et/ou automatiques, par exemple de soudure, de manipulation, de pliage, entre autres, sont réalisées sur les modules qui constituent un risque de détérioration et d'endommagement des modules photovoltaïques 5, notamment de casse.

Or, pour un tel assemblage photovoltaïque 10, en cas de dysfonctionnement d'un ou plusieurs des modules photovoltaïques 5, il est nécessaire de procéder au décollement mécanique des modules photovoltaïques 5 au niveau des couches d'adhésion 4, ce qui entraîne généralement des détériorations des modules photovoltaïques 5, du support rigide 6 et/ou des moyens de connexion électrique 7, du fait notamment de la forte adhésion des couches d'adhésion 4 entre le support rigide 6 et les modules photovoltaïques 5.

La figure 2 représente un schéma-blocs qui illustre un exemple de mise en oeuvre du procédé de fabrication et d'inspection d'un assemblage photovoltaïque 10 conforme à l'invention.

Le procédé selon l'invention permet avantageusement de réaliser la fabrication et l'inspection d'un assemblage photovoltaïque 10, par exemple du type de celui décrit en référence à la figure 1, qui comprend un support 6, plusieurs modules photovoltaïques 5, comprenant chacun des cellules photovoltaïques 3, et autant de couches d'adhésion liquides 4 à base d'un matériau polymère réticulable, entre le support 6 et chaque module photovoltaïque 5.

Ainsi, la première étape A) du procédé consiste à réaliser la dépose des couches d'adhésion 4 sur le support 6. L'épaisseur de colle peut être comprise entre 10 µm et 1 mm, notamment entre 50 µm et 200 µm.

Le support 6 est préférentiellement de faible épaisseur. Il peut être rigide ou souple. Dans le cas d'une application spatiale, c'est un support rigide comportant par exemple une structure en nid d'abeilles, par exemple en aluminium.

La technique de dépose sur le support 6 peut être variable, et correspondre par exemple à une dépose par enduction ou par spray. La dépose de colle est avantageusement réalisée aux endroits du support 6 sur lesquels sont reçus les modules photovoltaïques 5. Sur ces endroits, la dépose peut être totale ou partielle.

Le matériau polymère réticulable formant la colle est avantageusement choisi parmi la familles des silicones, et peut par exemple être du polydiméthylsiloxane (PMDS).

Il est à noter que l'aspect transparent après réticulation n'est pas forcément nécessaire car la face utile des cellules 3 se situe en face avant. Toutefois, dans le cas de cellules bifaciales, il est souhaitable que le matériau polymère réticulable soit transparent.

Ensuite, le procédé comporte une étape B) d'assemblage des modules photovoltaïques 5 sur le support 6 recouvert des couches d'adhésion.

Les modules photovoltaïques 5 sont ainsi posés sur le support 6 encollé. Cet assemblage est avantageusement réalisé de manière à éliminer les bulles susceptibles de se former sous les modules 5. En effet, au moindre vide présent dans la colle (bulle, zone non encollée, etc.), il existe un risque de non tenue au vide et donc à l'environnement spatial, même s'il existe une certaine tolérance sur la taille des bulles.

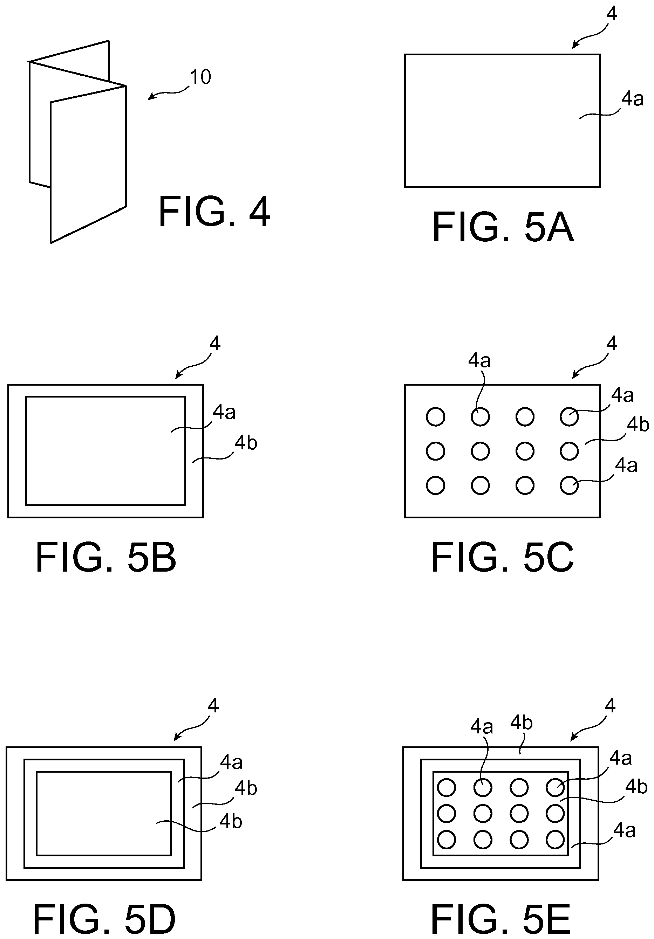

A ce stade, une étape C) de réticulation partielle des couches d'adhésion liquide 4 à base d'un matériau polymère réticulable est préférentiellement réalisée pour former des couches d'adhésion partiellement réticulées, comme visibles sur les figures 5A à 7A décrites par la suite. De cette façon, elles présentent avantageusement une force d'adhésion réversible ou non définitive, qui autorise un décollement ultérieur.

Il faut noter qu'en variante, l'étape C) de réticulation partielle pourrait précéder l'étape B) d'assemblage.

La réticulation partielle est réalisée préférentiellement sous un éclairage ultraviolet. En variante, toute autre méthode d'apport d'énergie est possible, par exemple par infrarouge, par laser, par exposition à la chaleur, entre autres.

La réticulation partielle est réalisée avec un degré ou taux de réticulation moyen compris entre 10 % et 60 %, préférentiellement entre 20 % et 50 %, en volume ou en masse. Il faut noter qu'entre le module et le support, certaines zones peuvent être non réticulées et d'autre réticulées à plus de 60%. L'objectif est de créer des liaisons doubles permettant d'assurer une adhésion mécanique suffisante pour de la préhension et de la manipulation de l'assemblage photovoltaïque 10. A l'issue d'une finalisation de réticulation, comme décrit par la suite avec l'étape F), le degré de réticulation final sera supérieur à 60 % en moyenne, voire compris entre 70 % et 90 %, généralement. Il faut noter que la réticulation à 100 % n'est pratiquement jamais atteinte.

Le taux de réticulation peut être mesuré par méthode DSC (pour « Differential Scanning Calorimeter » en anglais), mesure relative par calcul de l'air sous le pic de réticulation, suivant la méthode d'enthalpie de la norme IEC 62788 adaptée à des encapsulants silicones : on réalise un balayage en température, de 40°C à 200°C, d'un échantillon frais d'encapsulant. Ce balayage fait apparaître le pic de réticulation. En calculant l'air sous le pic de la courbe, on obtient l'enthalpie de la réaction totale de réticulation, c'est-à-dire l'énergie libérée par la réaction exothermique de réticulation. Lorsque l'on réalise la même mesure et le même calcul pour un échantillon partiellement pré-réticulé, la valeur d'enthalpie est inférieure à celle du produit frais, puisqu'elle correspond à la fin de la réticulation. On parle d'enthalpie résiduelle. La différence entre les deux enthalpies nous donne le pourcentage de la réaction de réticulation effectué pendant la pré-réticulation.

La réticulation peut être contrôlée de plusieurs manières : temps d'exposition et puissance lumineuse, en plus de la formulation de la colle choisie. Avantageusement, le temps d'exposition sera très court pour gagner en temps de fabrication.

Une fois la réticulation partielle terminée, une étape D) de connexion électrique consistant à relier électriquement les modules photovoltaïques 5 à des moyens de connexion électrique 7 du support 6, est mise en oeuvre. En particulier, cette étape D) permet de réaliser les soudures entre les connexions électriques sortant des modules photovoltaïques 5 et un harnais électrique 7 du support 6.

Par la suite, une étape E) d'inspection du fonctionnement électrique et mécanique des modules photovoltaïques 5 est mise en oeuvre.

En effet, l'intégrité des modules photovoltaïques 5 doit à ce stade être vérifiée afin d'envisager un décollement éventuel d'un ou plusieurs modules photovoltaïques 5 pendant que la réticulation est encore partielle, et donc avant d'obtenir une réticulation totale qui entraînerait de grandes difficultés de non détérioration en cas de décollement comme selon la pratique de l'art antérieur.

Cette étape E) d'inspection du fonctionnement électrique et mécanique des modules photovoltaïques 5 comprend tout particulièrement la réalisation d'un test électrique de chaque ensemble de cellules photovoltaïques 3. Préférentiellement, ce test électrique est un test de type DIV (Dark IV). Ce test peut aussi s'accompagner d'une inspection visuelle et/ou d'une caractérisation optique.

Il est à noter que, préalablement à leur positionnement sur le support 6, chaque module photovoltaïque 5 est testé électriquement, notamment par le même type de test que celui mis en oeuvre dans l'étape E) d'inspection. Toutefois, après les opérations manuelles et/ou automatiques liées à la mise en place des modules 5 sur le support 6, il faut effectuer un nouveau test électrique qui fait l'objet de cette étape d'inspection E).

Ainsi, en cas de fonctionnement correct détecté à l'issue de l'étape E), symbolisé par la référence O sur la figure 2, une étape F) de finalisation de la réticulation des couches d'adhésion partiellement réticulées est réalisée. Les modules photovoltaïques 5 sont donc conservés sur le support 6.

L'étape F) de finalisation de la réticulation peut être réalisée par exposition de l'assemblage photovoltaïque 10 à température ambiante, notamment entre 20 et 30°C, pendant une durée prédéterminée, notamment supérieure à 24h, celle-ci pouvant être fonction de la colle choisie. Il est également possible d'exposer l'assemblage photovoltaïque 10 à un apport d'énergie externe, notamment par chauffage ou exposition à des ondes infrarouges ou ultraviolettes. Il faut noter que plus la finalisation de la réticulation est lente et plus les contraintes thermomécaniques liées à l'adhésif seront minimisées. Toutefois, cette étape F) de finalisation de la réticulation peut éventuellement être suivie d'une étape E) additionnelle d'inspection, et si une réparation est nécessaire, elle devra être faite dans une durée assez courte, notamment inférieure à 24h, mieux inférieure à 12h.

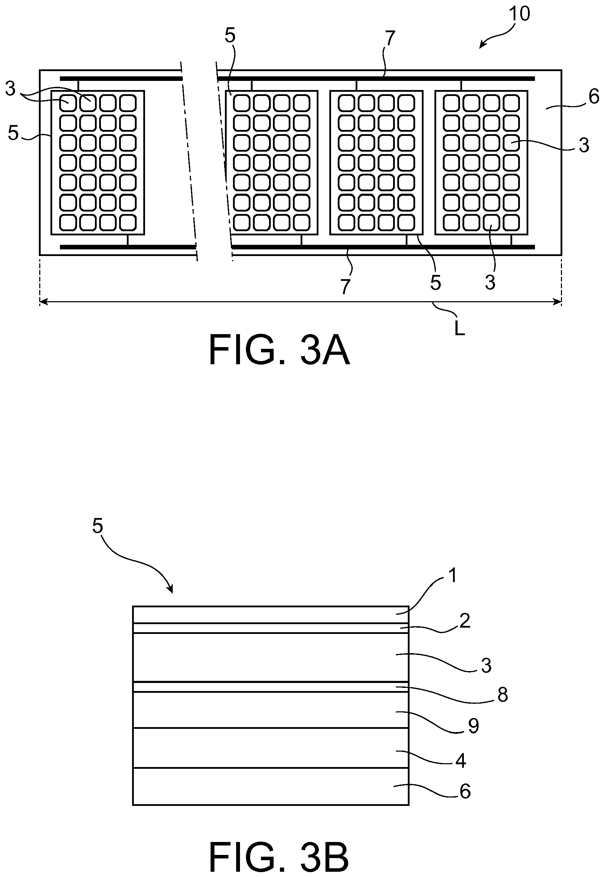

La figure 3A représente un exemple d'un assemblage photovoltaïque 10, différent de celui de la figure 1, obtenu par la mise en oeuvre du procédé décrit précédemment en référence à la figure 2. De plus, la figure 3B représente, selon une vue en coupe, un exemple de module photovoltaïque 5 d'un tel assemblage photovoltaïque 10.

Le support rigide 6, formant voile solaire, forme la face arrière de chaque module photovoltaïque 5. De plus, chaque module photovoltaïque 5 comporte : une face avant 1 en verre ; une première couche d'adhésif transparent 2 ; une ou plusieurs cellules photovoltaïques 3 ; une deuxième couche d'adhésif transparent 8 ; un substrat 9 formant la face arrière du module 5.

De plus, une couche d'adhésion 4 est utilisée entre chaque module photovoltaïque 5 et le support rigide 6 pour permettre la fixation des modules photovoltaïques 5 sur le support rigide 6, et ainsi la fabrication de l'assemblage photovoltaïque 10.

Ainsi, le module photovoltaïque 5 qui est collé sur la voile solaire ou support 6 est de type classique avec une face avant 1 et une face arrière 9, laquelle est collée sur le support 6 formant la voile spatiale destinée à être pliée.

Cet assemblage photovoltaïque 10 peut présenter une longueur L supérieure ou égale à 5 m, voire à 10 m, et comprendre une pluralité de modules photovoltaïques 5, par exemple au moins 30, positionnés sur le support 6.

Alors, une étape de pliage de l'assemblage photovoltaïque 10 peut être mise en oeuvre, notamment pour l'obtention d'un pliage en Z comme représenté sur la figure 4. Toutefois, il faut noter qu'une étape de pliage peut également avoir lieu avant l'étape E) d'inspection.

En revanche, en cas de fonctionnement incorrect détecté à l'issue de l'étape E), symbolisé par la référence N sur la figure 2, une étape G) d'enlèvement d'un ou plusieurs modules photovoltaïques 5 défectueux, et une étape H) de nettoyage du support 6 à l'endroit d'enlèvement du ou des modules photovoltaïques 5 défectueux sont mises en oeuvre.

Un fonctionnement incorrect peut par exemple être : une caractéristique IV ou DARK IV avec résistance parasite importante, une image en électroluminescence montrant des fissures ou des casses de cellules, une image en transient électroluminescence (ou tout autre technique permettant de caractériser l'interface de collage) montrant des défauts de collage importants. Le fonctionnement correct est défini par opposition à un fonctionnement incorrect.

En effet, le ou les modules photovoltaïques 5 qui sont jugés comme mauvais doivent être décollés pour être remplacés. Cette étape peut être réalisée mécaniquement car l'assemblage n'est pas définitivement fixé du fait de la réticulation partielle. L'enlèvement ou décollage peut ainsi être réalisé à l'aide d'une lame mince de type scalpel ou d'autres outils permettant de faciliter cette étape. La lame est glissée sous le ou les modules 5 afin de procéder au décollement.

Cette opération est effectuée de sorte à ne pas endommager le support 6, le risque étant de perdre le support et les différents modules photovoltaïques 5 déjà collés et fonctionnels. Il faut noter que plus le degré de réticulation est faible et plus cette étape d'enlèvement est aisée et rapide. Une réticulation partielle permet donc de réduire le temps passé à la réparation en cas de défaillance constatée.

L'étape H) de nettoyage est prévue quant à elle pour enlever les résidus de colle non enlevés par la lame mince. Là encore, plus le degré de réticulation est faible et plus cette étape de nettoyage est aisée et rapide.

A l'issue de l'étape H) de nettoyage, le procédé recommence au niveau de l'étape A) pour préparer la ou les zones nettoyées à recevoir un ou plusieurs nouveaux modules photovoltaïques 5.

L'étape C) de réticulation partielle des couches d'adhésion liquides 4 à base d'un matériau polymère réticulable peut être envisagée selon différentes approches, telles que représentées par exemple sur les figures 5A à 7A.

Ainsi, la réticulation partielle peut correspondre à une réticulation partielle du volume total d'une couche d'adhésion 4. Sur la figure 5A, la zone pré-réticulée 4a correspond au volume total de la couche d'adhésion 4 qui est pré-réticulé.

En variante, il est aussi possible de pré-réticuler partiellement le volume d'une couche d'adhésion 4, comme représenté sur les figures 5B à 7A.

Ainsi, sur la figure 5B, une zone centrale 4a est pré-réticulée tandis que la périphérie de la surface de la couche d'adhésion 4 comprend une zone non réticulée 4b. Sur la figure 5C, les zones pré-réticulées 4a sont sous forme de points espacés régulièrement les uns des autres, tandis que le restant de la surface de la couche d'adhésion 4 correspond à une zone non réticulée 4b.

Sur la figure 5D, un cadre rectangulaire correspond à une zone pré-réticulée 4a tandis que le restant de surface de la couche d'adhésion 4 correspond à une zone non réticulée 4b. Sur la figure 5E, les motifs des figures 5C et 5D sont combinés ensemble.

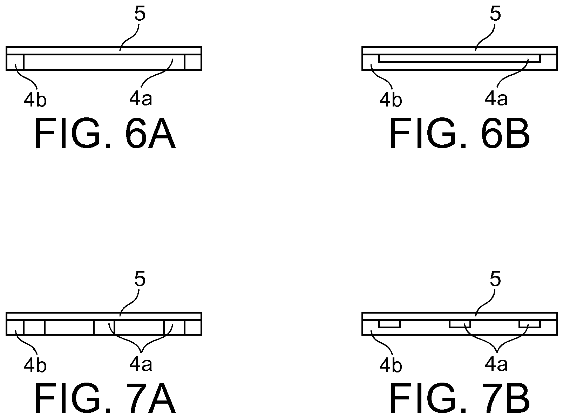

Les figures 6A et 6B représentent des variations de réticulation partielle dans l'épaisseur de la couche d'adhésion 4 de la figure 5B. Ainsi, comme sur la figure 6A, la totalité de l'épaisseur peut être pré-réticulée. En variante, une partie seulement de l'épaisseur est pré-réticulée, en particulier celle 4a en contact avec le module photovoltaïque 5, comme visible sur la figure 6B.

De même, les figures 7A et 7B représentent des variations de réticulation partielle dans l'épaisseur de la couche d'adhésion 4 de la figure 5C. Ainsi, comme sur la figure 7A, la totalité de l'épaisseur peut être pré-réticulée. En variante, une partie seulement de l'épaisseur est pré-réticulée, en particulier celle 4a en contact avec le module photovoltaïque 5, comme visible sur la figure 7B.

Ainsi, la réticulation partielle peut correspondre à une réticulation partielle de la surface et/ou du volume d'une couche d'adhésion 4, la fraction restant n'étant pas pré-réticulée. Une étape de masquage peut ainsi être mise en oeuvre par le biais de masques selon des motifs variés, par exemple des points, des lignes, des cadres, etc., pour obtenir la réticulation partielle.

La réticulation partielle peut donc aussi signifier que le degré de réticulation varie dans l'épaisseur de la couche d'adhésion, avec une réticulation partielle réalisée du côté des modules photovoltaïques 5. Bien entendu, une combinaison de réticulation partielle en épaisseur, en motif et en surface est possible.

Bien entendu , l'invention est définie par la portée des revendications ci-jointes et elle n'est pas limitée aux exemples de réalisation qui viennent d'être décrits.

## Revendications

1. Procédé de fabrication et d'inspection d'un assemblage photovoltaïque (10), comportant :
- un support (6),
- au moins un module photovoltaïque (5), comprenant au moins une cellule photovoltaïque (3) entre une première couche (1) transparente formant une face avant dudit au moins un module photovoltaïque (5) et le support (6),
- au moins une couche d'adhésion (4) à base d'un matériau polymère réticulable, disposée entre le support (6) et ledit au moins un module photovoltaïque (5), **caractérisé en ce qu'**il comporte les étapes suivantes :
- une étape A) de dépose de ladite au moins une couche d'adhésion (4) sur le support (6),
- une étape B) d'assemblage dudit au moins un module photovoltaïque (5) sur le support (6) recouvert de ladite au moins une couche d'adhésion (4),
- une étape C) de réticulation partielle de ladite au moins une couche d'adhésion (4) à base d'un matériau polymère réticulable pour former au moins une couche d'adhésion partiellement réticulée (4a, 4b), présentant un pouvoir d'adhésion autorisant un enlèvement ultérieur dudit au moins un module photovoltaïque (5),
- une étape D) de connexion électrique consistant à relier électriquement ledit au moins un module photovoltaïque (5) à des moyens de connexion électrique (7) du support (6),
- une étape E) d'inspection du fonctionnement électrique et mécanique dudit au moins un module photovoltaïque (5),
- en cas de fonctionnement correct détecté à l'issue de l'étape E), une étape F) de finalisation de la réticulation de ladite au moins une couche d'adhésion partiellement réticulée (4a, 4b),
- en cas de fonctionnement incorrect détecté à l'issue de l'étape E), une étape G) d'enlèvement d'au moins un module photovoltaïque (5) défectueux, puis retour à l'étape A) en vue de l'assemblage d'un ou plusieurs nouveaux modules photovoltaïques (5).

2. Procédé selon la revendication 1, **caractérisé en ce que** l'étape G) est suivie d'une étape H) de nettoyage du support (6) à l'endroit d'enlèvement dudit au moins un module photovoltaïque (5) défectueux avant retour à l'étape A).

3. Procédé selon la revendication 1 ou 2, **caractérisé en ce que** l'épaisseur de ladite au moins une couche d'adhésion (4) est comprise entre 10 µm et 1 mm, notamment entre 50 µm et 200 µm.

4. Procédé selon l'une des revendications précédentes, **caractérisé en ce que** l'étape B) d'assemblage précède l'étape C) de réticulation partielle.

5. Procédé selon l'une des revendications 1 à 3, **caractérisé en ce que** l'étape B) d'assemblage suit l'étape C) de réticulation partielle.

6. Procédé selon l'une quelconque des revendications précédentes, **caractérisé en ce que** le taux de réticulation moyen mis en oeuvre lors de l'étape C) de réticulation partielle est compris entre 10 % et 60 %, notamment entre 20 % et 50 %, en volume ou en masse.

7. Procédé selon l'une quelconque des revendications précédentes, **caractérisé en ce que** le matériau polymère réticulable de ladite au moins une couche d'adhésion (4) est choisi parmi la famille des silicones.

8. Procédé selon l'une quelconque des revendications précédentes, **caractérisé en ce que** l'étape E) d'inspection du fonctionnement électrique et mécanique dudit au moins un module photovoltaïque (5) comprend la réalisation d'un test électrique de chaque ensemble d'une ou plusieurs cellules photovoltaïques (3) dudit au moins un module photovoltaïque (5), notamment un test d'électroluminescence, de photoluminescence, de type DIV (Dark IV) et/ou de type LIV (Light IV).

9. Procédé selon l'une quelconque des revendications précédentes, **caractérisé en ce que** l'étape F) de finalisation de la réticulation de ladite au moins une couche d'adhésion partiellement réticulée (4a, 4b) est réalisée par exposition de l'assemblage photovoltaïque (10) à température ambiante pendant une durée supérieure à 24h.

10. Procédé selon l'une quelconque des revendications 1 à 9, **caractérisé en ce que** l'étape F) de finalisation de la réticulation de ladite au moins une couche d'adhésion partiellement réticulée (4a, 4b) est réalisée par exposition de l'assemblage photovoltaïque (10) à un apport d'énergie externe, notamment par chauffage ou exposition à des ondes infrarouges et/ou ultraviolettes, et optionnellement **en ce que** l'étape F) de finalisation de la réticulation est suivie d'une étape E) additionnelle d'inspection.

11. Procédé selon l'une quelconque des revendications précédentes, **caractérisé en ce que** l'étape F) de finalisation de la réticulation est suivie d'une étape de pliage de l'assemblage photovoltaïque (10), notamment d'un pliage en Z, et/ou **en ce que** l'étape E) d'inspection est précédée d'une étape de pliage de l'assemblage photovoltaïque (10), notamment d'un pliage en Z.

12. Procédé selon l'une quelconque des revendications précédentes, **caractérisé en ce que** l'étape C) de réticulation partielle de ladite au moins une couche d'adhésion (4) à base d'un matériau polymère réticulable comporte la réticulation partielle du volume total de ladite au moins une couche d'adhésion (4).

13. Procédé selon l'une quelconque des revendications 1 à 11, **caractérisé en ce que** l'étape C) de réticulation partielle de ladite au moins une couche d'adhésion (4) à base d'un matériau polymère réticulable comporte la réticulation partielle du volume total de ladite au moins une couche d'adhésion (4), et optionnellement **en ce que** la réticulation partielle est réalisée sur une ou plusieurs zones (4a) de la surface de ladite au moins une couche d'adhésion (4), notamment sous la forme d'un ou plusieurs motifs, et/ou sur une partie ou la totalité de l'épaisseur de ladite au moins une couche d'adhésion (4).

14. Procédé selon l'une quelconque des revendications précédentes, **caractérisé en ce que** ladite au moins une couche d'adhésion (4) à base d'un matériau polymère réticulable est à l'état liquide.

15. Procédé selon l'une quelconque des revendications précédentes, **caractérisé en ce que** ledit au moins un module photovoltaïque (5) comporte une première couche (1) transparente formant une face avant dudit au moins un module photovoltaïque (5), une deuxième couche (9) formant une face arrière dudit au moins un module photovoltaïque (5), et une pluralité de cellules photovoltaïques (3) reliées électriquement entre elles et disposées côte à côte entre la première couche (1) et la deuxième couche (9).

## Patentansprüche

1. Verfahren zur Herstellung und Überprüfung einer Photovoltaik-Baugruppe (10), beinhaltend:
- Einen Träger (6),
- mindestens ein Photovoltaikmodul (5), das mindestens eine Photovoltaikzelle (3) umfasst zwischen einer ersten transparenten Schicht (1), die eine vordere Fläche des mindestens einen Photovoltaikmoduls (5) bildet, und dem Träger (6),
- mindestens eine Haftschicht (4), auf einem vernetzbaren Polymermaterial basierend, die zwischen dem Träger (6) und dem mindestens einen Photovoltaikmodul (5) angeordnet ist, **dadurch gekennzeichnet, dass** es die folgenden Schritte beinhaltend:
- Einen Schritt A) des Aufbringens der mindestens einen Haftschicht (4) auf dem Träger (6),
- einen Schritt B) der Montage des mindestens einen Photovoltaikmoduls (5) auf dem Träger (6), der mit der mindestens einen Haftschicht (4) bedeckt ist,
- einen Schritt C) der teilweisen Vernetzung der mindestens einen Haftschicht (4), auf einem vernetzbaren Polymermaterial basierend, um mindestens eine teilweise vernetzte Haftschicht (4a, 4b) zu bilden, die ein Haftvermögen aufweist, das ein anschließendes Entfernen des mindestens einen Photovoltaikmoduls (5) ermöglicht,
- einen Schritt D) der elektrischen Verbindung, der darin besteht, das mindestens eine Photovoltaikmodul (5) elektrisch mit elektrischen Verbindungsmitteln (7) des Trägers (6) zu verbinden,
- einen Schritt E) der Überprüfung des elektrischen und mechanischen Betriebs des mindestens eines Photovoltaikmoduls (5),
- im Falle eines festgestellten ordnungsgemäßen Betriebs nach Schritt E), einen Schritt F) der Fertigstellung der Vernetzung der mindestens einen teilweise vernetzten Haftschicht (4a, 4b),
- im Falle eines nach Schritt E) festgestellten fehlerhaften Betriebs, einen Schritt G) des Entfernens mindestens eines defekten Photovoltaikmoduls (5) und anschließende Rückkehr zu Schritt A) zur Montage eines oder mehrerer neuer Photovoltaikmodule (5).

2. Verfahren nach Anspruch 1, **dadurch gekennzeichnet, dass** der Schritt G) durch einen Schritt H) gefolgt ist des Reinigens des Trägers (6) an der Stelle des Entfernens des mindestens einen defekten Photovoltaikmoduls (5), vor der Rückkehr zu Schritt A).

3. Verfahren nach Anspruch 1 oder 2, **dadurch gekennzeichnet, dass** die Dicke der mindestens einen Haftschicht (4) zwischen 10 µm und 1 mm liegt, insbesondere zwischen 50 µm und 200 µm.

4. Verfahren nach einem der vorhergehenden Ansprüche, **dadurch gekennzeichnet, dass** der Schritt B) der Montage dem Schritt C) der teilweisen Vernetzung vorausgeht.

5. Verfahren nach einem der Ansprüche 1 bis 3, **dadurch gekennzeichnet, dass** der Schritt B) der Montage auf den Schritt C) der teilweisen Vernetzung folgt.

6. Verfahren nach einem der vorhergehenden Ansprüche, **dadurch gekennzeichnet, dass** die durchschnittliche Vernetzungsrate, die im Schritt C) der teilweisen Vernetzung angewandt wurde, zwischen 10 % und 60 % an Volumen oder an Masse liegt, insbesondere zwischen 20 % und 50 %.

7. Verfahren nach einem der vorhergehenden Ansprüche, **dadurch gekennzeichnet, dass** das vernetzbare Polymermaterial der mindestens einen Haftschicht (4) aus der Familie der Silikone ausgewählt ist.

8. Verfahren nach einem der vorhergehenden Ansprüche, **dadurch gekennzeichnet, dass** der Schritt E) der Überprüfung des elektrischen und mechanischen Betriebs des mindestens einen Photovoltaikmoduls (5) die Durchführung einer elektrischen Prüfung jeder Anordnung von einer oder mehreren Photovoltaikzellen (3) des mindestens einen Photovoltaikmoduls (5) umfasst, insbesondere eine Prüfung der Elektrolumineszenz und der Photolumineszenz vom Typ DIV (Dark IV) und/oder vom Typ LIV (Light IV).

9. Verfahren nach einem der vorhergehenden Ansprüche, **dadurch gekennzeichnet, dass** der Schritt F) der Fertigstellung der Vernetzung der mindestens einen teilweise vernetzten Haftschicht (4a, 4b) durch Aussetzen der Photovoltaik-Baugruppe (10) an eine Raumtemperatur über einen Zeitraum von mehr als 24 Std. durchgeführt wird.

10. Verfahren nach einem der Ansprüche 1 bis 9, **dadurch gekennzeichnet, dass** der Schritt F) der Fertigstellung der Vernetzung der mindestens einen teilweise vernetzten Haftschicht (4a, 4b) durch Aussetzen der Photovoltaik-Baugruppe (10) an eine externe Energiezufuhr durchgeführt wird, insbesondere durch Erhitzen oder Aussetzen an Infrarot- und/oder Ultraviolettwellen, und optional, dass der Schritt F) der Fertigstellung der Vernetzung von einem zusätzlichen Schritt E) der Überprüfung gefolgt ist.

11. Verfahren nach einem der vorhergehenden Ansprüche, **dadurch gekennzeichnet, dass** der Schritt F) der Fertigstellung der Vernetzung von einem Schritt der Faltung der Photovoltaik-Baugruppe (10) gefolgt ist, insbesondere einer Z-Faltung, und/oder dass dem Schritt E) der Überprüfung ein Schritt der Faltung der Photovoltaik-Baugruppe (10) vorausgeht, insbesondere einer Z-Faltung.

12. Verfahren nach einem der vorhergehenden Ansprüche, **dadurch gekennzeichnet, dass** der Schritt C) der teilweisen Vernetzung der mindestens einen Haftschicht (4), auf einem vernetzbaren Polymermaterial basierend, die teilweise Vernetzung des Gesamtvolumens der mindestens einen Haftschicht (4) beinhaltet.

13. Verfahren nach einem der Ansprüche 1 bis 11, **dadurch gekennzeichnet, dass** der Schritt C) der teilweisen Vernetzung der mindestens einen Haftschicht (4), auf einem vernetzbaren Polymermaterial basierend, die teilweise Vernetzung des Gesamtvolumens der mindestens einen Haftschicht (4) beinhaltend, und optional, dass die teilweise Vernetzung über einen oder mehrere Bereiche (4a) der Oberfläche der mindestens einen Haftschicht (4) durchgeführt wird, insbesondere in Form eines oder mehrerer Muster, und/oder über einen Teil oder die gesamte Dicke der mindestens einen Haftschicht (4).

14. Verfahren nach einem der vorhergehenden Ansprüche, **dadurch gekennzeichnet, dass** die mindestens eine Haftschicht (4), auf einem vernetzbaren Polymermaterial basierend, in flüssigem Zustand ist.

15. Verfahren nach einem der vorhergehenden Ansprüche, **dadurch gekennzeichnet, dass** das mindestens eine Photovoltaikmodul (5) eine erste transparente Schicht (1) beinhaltet, die eine vordere Fläche des mindestens einen Photovoltaikmoduls (5) bildet, eine zweite Schicht (9), die eine hintere Fläche des mindestens einen Photovoltaikmoduls (5) bildet, und eine Vielzahl von Photovoltaikzellen (3), die elektrisch miteinander verbunden und nebeneinander zwischen der ersten Schicht (1) und der zweiten Schicht (9) angeordnet sind.

## Claims

1. Method for fabricating and inspecting a photovoltaic assembly (10), including:
- a base (6),
- at least one photovoltaic module (5), comprising at least one photovoltaic cell (3) between a first transparent layer (1) forming a front face of said at least one photovoltaic module (5) and the base (6),
- at least one adhesion layer (4) based on a crosslinkable polymer material, disposed between the base (6) and said at least one photovoltaic module (5), **characterised in that** it includes the following steps:
- a step A) of depositing said at least one adhesion layer (4) on the base (6),
- a step B) of assembling said at least one photovoltaic module (5) on the base (6) covered by said at least one adhesion layer (4),
- a step C) of partially crosslinking said at least one adhesion layer (4) based on a crosslinkable polymer material to form at least one partially crosslinked adhesion layer (4a, 4b), having an adhesive power allowing a subsequent removal of said at least one photovoltaic module (5),
- an electrical connection step D) consisting in electrically connecting said at least one photovoltaic module (5) to electrical connection means (7) of the base (6),
- a step E) of inspecting the mechanical and electrical functioning of said at least one photovoltaic module (5),
- in the event of correct functioning being detected at the outcome of step E), a step F) of finalising the crosslinking of said at least one partially crosslinked adhesion layer (4a, 4b),
- in the event of incorrect functioning being detected at the outcome of step E), a step G) of removing at least one defective photovoltaic module (5), then return to step A) in view of assembling one or more new photovoltaic modules (5).

2. Method according to claim 1, **characterised in that** step G) is followed by a step H) of cleaning the base (6) at the location of removal of said at least one defective photovoltaic module (5) before return to step A).

3. Method according to claim 1 or 2, **characterised in that** the thickness of said at least one adhesion layer (4) is between 10 µm and 1 mm, particularly between 50 µm and 200 µm.

4. Method according to one of the preceding claims, **characterised in that** the assembly step B) precedes the partial crosslinking step C).

5. Method according to one of claims 1 to 3, **characterised in that** the assembly step B) follows the partial crosslinking step C).

6. Method according to any one of the preceding claims, **characterised in that** the average crosslinking rate implemented during the partial crosslinking step C) is between 10% and 60%, particularly between 20% and 50%, by volume or by mass.

7. Method according to any one of the preceding claims, **characterised in that** the crosslinkable polymer material of said at least one adhesion layer (4) is selected from the silicone family.

8. Method according to any one of the preceding claims, **characterised in that** step E) of inspecting the mechanical and electrical functioning of said at least one photovoltaic module (5) comprises performing an electrical test of each set of one or more photovoltaic cells (3) of said at least one photovoltaic module (5), particularly an electroluminescence, photoluminescence, DIV (Dark IV)-type and/or LIV (Light Iv)-type test.

9. Method according to any one of the preceding claims, **characterised in that** step F) of finalising the crosslinking of said at least one partially crosslinked adhesion layer (4a, 4b) is performed by exposing the photovoltaic assembly (10) to ambient temperature for a duration greater than 24 h.

10. Method according to any one of claims 1 to 9, **characterised in that** step F) of finalising the crosslinking of said at least one partially crosslinked adhesion layer (4a, 4b) is performed by exposing the photovoltaic assembly (10) to an external energy input, particularly by heating or exposure to infrared and/or ultraviolet waves, and optionnally **in that** the crosslinking finalisation step F) is followed by an additional inspection step E).

11. Method according to any one of the preceding claims, **characterised in that** the crosslinking finalisation step F) is followed by a step of bending the photovoltaic assembly (10), particularly of a Z-shaped bending, and/or **in that** the inspection step E) is preceded by a step of bending the photovoltaic assembly (10), particularly of a Z-shaped bending.

12. Method according to any one of the preceding claims, **characterised in that** step C) of partially crosslinking said at least one adhesion layer (4) based on a crosslinkable polymer material includes partially crosslinking the total volume of said at least one adhesion layer (4).

13. Method according to any one of claims 1 to 11, **characterised in that** step C) of partially crosslinking said at least one adhesion layer (4) based on a crosslinkable polymer material includes partially crosslinking the total volume of said at least one adhesion layer (4), and optionally **in that** the partial crosslinking is performed on one or more areas (4a) of the surface of said at least one adhesion layer (4), particularly in the form of one or more patterns, and/or on a portion or the whole of the thickness of said at least one adhesion layer (4).

14. Method according to any one of the preceding claims, **characterised in that** said at least one adhesion layer (4) based on a crosslinkable polymer material is in the liquid state.

15. Method according to any one of the preceding claims, **characterised in that** said at least one photovoltaic module (5) includes a first transparent layer (1) forming a front face of said at least one photovoltaic module (5), a second layer (9) forming a rear face of said at least one photovoltaic module (5), and a plurality of photovoltaic cells (3) electrically connected to one another and disposed side by side between the first layer (1) and the second layer (9).
